# FASCICULE DE BREVET EUROPEEN

(11) **EP 1 014 100 B1**
(45) Date de publication et mention de la délivrance du brevet: **06.05.2004**
(21) Numéro de dépôt: 99402957.7
(22) Date de dépôt: 26.11.1999
(51) Int. Cl.: G01R 31/02

(54) **Dispositif de détection de coupure d'une ligne électrique, en particulier d'une ligne téléphonique**
Anordung zur Ermittlung einer Unterbrechung in einer elektrischen Leitung, inbesondere einer Telefonleitung
Appliance for detecting an open circuit in an electrical line, in particular a telephone line

(30) Priorité: 18.12.1998 FR 9816044
(43) Date de publication de la demande: 28.06.2000
(73) Titulaire: ATRAL, F-38190 Crolles (FR)
(72) Inventeur: Lefèbvre, Thierry Yves André, 38240 Meylan (FR)
(74) Mandataire: Casalonga, Axel

(56) Documents cités:
- DE-A- 3 040 806
- US-A- 3 887 824

## Description

La présente invention concerne un dispositif de détection de coupure de ligne électrique, notamment d'une ligne téléphonique.

Les dispositifs de détection de coupure de ligne téléphonique actuellement utilisés comprennent un relais monostable qui est à l'état collé en présence de la tension de la ligne téléphonique et se met à son état stable décollé après une durée déterminée d'absence de la tension de ligne téléphonique. De tels dispositifs de détection nécessitent l'utilisation d'une alimentation extérieure en énergie électrique, US 3,887,824 décrit un circuit de surveillance de liaison pour des installations de centraux de téléscription, qui reconnait une coupure de ligne.

La présente invention, selon la revendication 1, a pour objet un dispositif de détection de coupure d'une ligne électrique ne faisant pas appel à une telle alimentation extérieure en énergie électrique.

Le dispositif de détection d'une coupure d'une ligne électrique en particulier d'une ligne téléphonique, comprend un relais bistable comprenant un organe mobile de changement d'état susceptible d'être activé par au moins une bobine et dont les plots de connexion extérieure sont susceptibles d'être reliés à des moyens extérieurs, des moyens pour délivrer une impulsion électrique à ladite bobine lors de la mise sous tension de ladite ligne électrique et produite par l'énergie électrique de cette dernière, afin de placer ledit relais à un premier état, des moyens pour délivrer une impulsion électrique à ladite bobine lors de la coupure de ladite ligne électrique et produite par des moyens de stockage d'énergie électrique chargés par la ligne électrique, afin de placer ledit relais à un second état.

Selon une variante de l'invention, lesdits moyens pour délivrer une impulsion électrique à la seconde bobine comprennent de préférence des moyens pour retarder d'un délai prédéterminé cette impulsion électrique par rapport au début d'une coupure de la ligne électrique et pour ne délivrer cette impulsion électrique que si cette coupure est maintenue pendant une durée au moins égale audit délai.

Selon une autre variante de l'invention, le dispositif de détection comprend de préférence des moyens de commande agissant sur lesdits moyens pour délivrer lesdites impulsions électriques en fonction de la valeur de la tension de ladite ligne électrique par rapport à une valeur de référence.

Selon une autre variante de l'invention, lesdits moyens pour délivrer lesdites impulsions électriques comprennent de préférence deux transistors dont les émetteurs sont reliés entre eux et dont les collecteurs sont respectivement reliés à une borne d'une première et d'une seconde bobines, lesdits émetteurs étant reliés à l'un desdits pôles via un condensateur de stockage d'énergie électrique et les bases desdits transistors étant reliées à la sortie d'un comparateur de commande susceptible de prendre un premier état lorsque la tension de la ligne électrique est supérieure à une valeur prédéterminée et un second état lorsque la tension de la ligne électrique est inférieure à cette valeur prédéterminée, les autres bornes desdites bobines étant reliées aux pôles de ladite ligne électrique, de telle sorte que lorsque la sortie dudit comparateur passe à son premier état, lesdits pôles sont connectés au travers d'une desdites bobines, d'un desdits transistors et dudit condensateur, l'impulsion électrique étant délivrée à cette bobine durant la charge de ce condensateur, et lorsque la sortie dudit comparateur passe à son second état, le condensateur chargé se décharge au travers de l'autre transistor et de l'autre bobine, l'impulsion électrique étant délivrée à cette autre bobine durant la décharge dudit condensateur.

Selon une autre variante de l'invention, lesdits moyens pour délivrer lesdites impulsions électriques comprennent deux transistors dont les émetteurs sont reliés entre eux et à une borne de ladite bobine et dont les collecteurs sont respectivement reliés aux pôles de la ligne électrique, l'autre borne de ladite bobine étant reliée à l'un des pôle de la ligne électrique via un condensateur, les bases desdits transistors étant reliées à la sortie d'un comparateur de commande susceptible de prendre un premier état lorsque la tension de la ligne électrique est supérieure à une valeur prédéterminée et un second état lorsque la tension de la ligne électrique est inférieure à cette valeur prédéterminée, de telle sorte que lorsque la sortie dudit comparateur passe à son premier état, lesdits pôles sont connectés au travers d'un desdits transistors, de ladite bobine et dudit condensateur, l'impulsion électrique étant délivrée à cette bobine durant la charge de ce condensateur, et que lorsque la sortie dudit comparateur passe à son second état, le condensateur chargé se décharge au travers de ladite bobine et de l'autre transistor, l'impulsion électrique étant délivrée à cette autre bobine durant la décharge dudit condensateur.

Selon une autre variante l'invention, le dispositif de détection comprend de préférence un autre condensateur de stockage d'énergie électrique de la ligne électrique, ce condensateur étant monté de façon à se décharger en cas de coupure de cette dernière et étant relié à une entrée dudit comparateur, de telle sorte que lorsque la tension délivrée par l'autre condensateur passe en deça de ladite valeur prédéterminée au bout d'un délai de retard par rapport à l'instant de la coupure, ledit comparateur passe à son second état précité.

La présente invention sera mieux comprise à l'étude de dispositifs de détection d'une coupure de ligne téléphonique, décrits à titres d'exemples non limitatifs et illustrés sur le dessin annexé dans lequel :
- la figure 1 représente une première variante d'un dispositif de détection selon l'invention ;
- et la figure 2 représente une seconde variante d'un dispositif de détection selon l'invention.

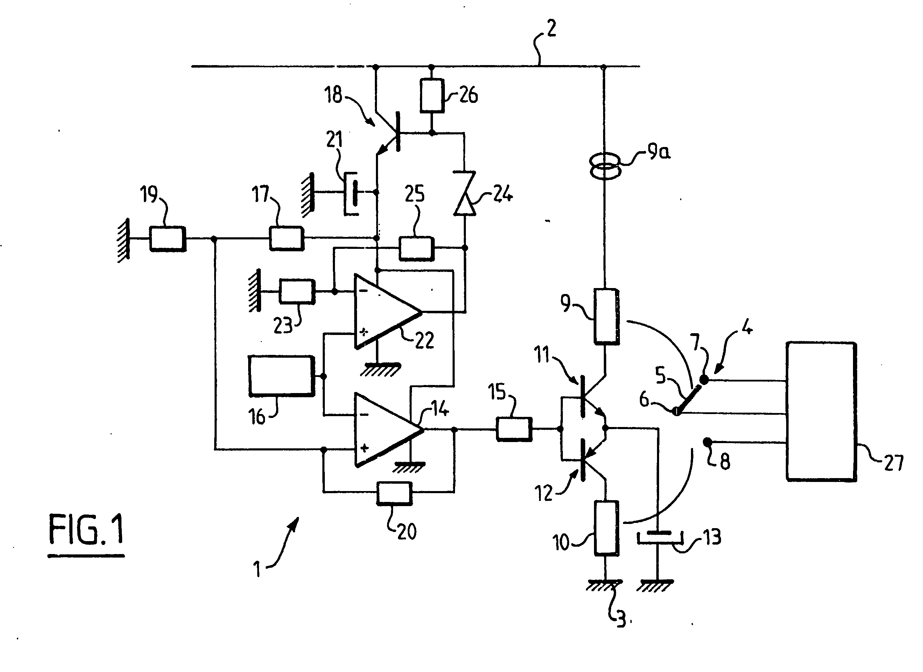

En se reportant à la figure 1, on voit qu'on a représenté un dispositif 1 de détection de coupure d'une ligne électrique constituée par une ligne téléphonique comprenant deux fils électriques représentant respectivement un pôle positif (+) 2 et un pôle de masse 3.

Le dispositif 1 comprend un relais bistable 4 qui comprend un organe mobile 5 de changement d'état susceptible d'occuper une première position stable dans laquelle il relie un plot commun 6 à un premier plot de contact 7 et une seconde position stable dans laquelle il relie le plot commun 6 à un second plot de contact 8.

Le relais 4 comprend en outre une première bobine 9 et une seconde bobine 10 qui, lorsqu'elles sont respectivement traversées par un courant électrique, permettent de faire passer l'organe mobile 5 respectivement à sa première position en contact avec le premier plot de contact 7 et à sa seconde position en contact avec le second plot de contact 8.

Le dispositif 1 comprend également un premier et un second transistors 11 et 12 et un condensateur 13 de stockage d'énergie électrique, qui sont montés de la manière suivante.

Le collecteur du transistor 11 est relié au pôle (+) 2 via la bobine 9 et un limiteur de courant 9a, et son émetteur est relié à l'émetteur du transistor 12 et au pôle de masse 3 par l'intermédiaire du condensateur 13. Le collecteur du transistor 12 est relié au pôle de masse 3 par l'intermédiaire de la bobine 10. Les bases des transistors 11 et 12 sont reliées entre elles et sont reliées à la sortie d'un comparateur 14 via une résistance 15.

Une entrée du comparateur 14 est reliée à un circuit 16 délivrant un signal correspondant à une tension de référence. Son autre entrée est reliée au pôle (+) 2 via une résistance 17 et un transistor 18, au pôle de masse 3 via une résistance 19 et à la sortie du comparateur 14 via une résistance 20.

Par ailleurs, le point commun entre la résistance 17 et le transistor 18 est relié au pôle de masse 3 via un condensateur 21.

Le dispositif 1 comprend en outre un amplificateur 22 dont les entrées sont respectivement reliées l'une au pôle de masse 3 via une résistance 23 et l'autre au circuit 16 délivrant le signal de tension de référence et dont la sortie est reliée à la base du transistor 18 via une diode Zener 24 et à son entrée reliée à la résistance 23 via une résistance 25, la base du transistor 18 étant par ailleurs reliée au pôle (+) 2 via une résistance 26.

Le comparateur 14, la référence 16 et l'amplificateur 22 sont alimentés via le point commun entre la résistance 17, le condensateur 21 et le transistor 18.

Par ailleurs, le plot commun 6 et les plots de contacts 7 et 8 du relais 4 sont respectivement reliés à un circuit récepteur 27, extérieur au dispositif de détection 1 et susceptible d'exploiter les signaux électriques résultant de la position de l'organe mobile 5.

On va décrire maintenant le fonctionnement du dispositif de détection 1, en considérant par exemple qu'en fonctionnement courant et normal, la tension minimum de la ligne téléphonique 2, 3 est de l'ordre de cinq volts et qu'à l'état de repos, cette tension est de l'ordre de quarante huit volts.

A la mise sous tension de la ligne téléphonique 2, 3, la tension aux bornes du condensateur 21 croît à travers le transistor 18 polarisé par la résistance 26. Cette tension est limitée, par exemple à 3,6 volts, grâce au régulateur composé de l'amplificateur 22 et de la diode zener 24.

La sortie du comparateur 14 est à son état "haut". En conséquence, le transistor 12 est bloqué et le transistor 11 est conducteur. Un courant circule au travers de la première bobine 9, du transistor 11 et du condensateur 13 qui se charge. Ce courant produit une impulsion électrique dans la bobine 9 qui dure jusqu'à ce que le condensateur 13 soit chargé, par exemple au plus quelques centièmes de seconde. Cette impulsion électrique provoque l'actionnement de l'organe mobile 5 du relais 4 de manière à l'amener à sa première position en contact avec le premier plot de contact 7 de ce relais ou le maintient dans cette position. Quand le condensateur 13 est chargé, le courant ne passe plus.

A la coupure de la ligne téléphonique 2, 3, la tension aux bornes du condensateur 21 décroît lentement par le fait que ce condensateur 21 se décharge en alimentant notamment le comparateur 14, le circuit de référence 16 et l'amplificateur 22. Lorsque cette tension atteint une valeur prédéterminée correspondant au seuil fixé par le circuit de référence 16, par exemple au bout d'environ une minute, la sortie du comparateur 14 change d'état et passe à son état "bas". Il en résulte que le transistor 11 se bloque et que le transistor 12 devient conducteur. Alors, le condensateur 13 se décharge au travers de la bobine 10 via le transistor 12, produisant une impulsion électrique qui provoque l'actionnement de l'organe mobile 5 du relais 4 pour le faire passer de sa première position précitée à sa seconde position en contact avec le second plot de contact 8 de ce relais.

Le retard à cet actionnement du relais 4 est principalement déterminé par les caractéristiques du condensateur 21, qui peuvent être prévues pour fixer un décalage de temps d'environ une minute. Ce décalage permet de maintenir l'organe mobile 5 du relais 4 à sa première position en cas de coupures de la ligne téléphonique 2, 3 de durée inférieure, résultant en particulier de la transmission par cette ligne téléphonique de signaux numériques comprenant des "zéros" de tension.

Le dispositif de détection 1 présente en outre les avantages suivants.

Un montage redresseur à pont de diode placé sur la ligne téléphonique 2, en amont du dispositif 1, permet de s'affranchir de la polarité de la ligne téléphonique 2, 3. Le montage différentiel permet de protéger le dispositif de détection 1 contre les surtensions qui pourraient être dues par exemple à la foudre.

L'amplificateur 22 amplifie la tension de référence fournie par le circuit de référence 16. La diode zener 24 introduit une tension de décalage pour annuler la tension base-émetteur du transistor 18. Les composants peuvent être choisis pour obtenir une tension de 3,6 volts. Le transistor 18 sert de ballast et absorbe l'écart entre la tension régulée et la tension de la ligne téléphonique 2, 3.

Le comparateur 22 et les résistances 17, 19 et 20 fournissent la comparaison des tensions.

Les transistors 11 et 12, le comparateur 14, la résistance 15, la tension de la ligne téléphonique 2, 3 et la tension du condensateur 13 constituent les moyens de commande du relais bistable 4.

Le condensateur 21 assure le décalage de temps entre l'instant de la coupure de la ligne téléphonique 2, 3 et l'instant du changement d'état du relais 4 lors de cette coupure.

Il résulte de ce qui précède que le dispositif de détection 1 proposé fonctionne sans alimentation électrique extérieure et n'utilise que l'énergie électrique délivrée par la ligne téléphonique 2, 3 d'une part à la mise sous tension de cette ligne et d'autre part lors de coupures de cette ligne grâce au stockage d'énergie électrique dans le condensateur 13 produisant l'impulsion d'actionnement du relais 4 après coupure de la ligne téléphonique 2, 3 et au condensateur 21 qui assure le retard de cet actionnement.

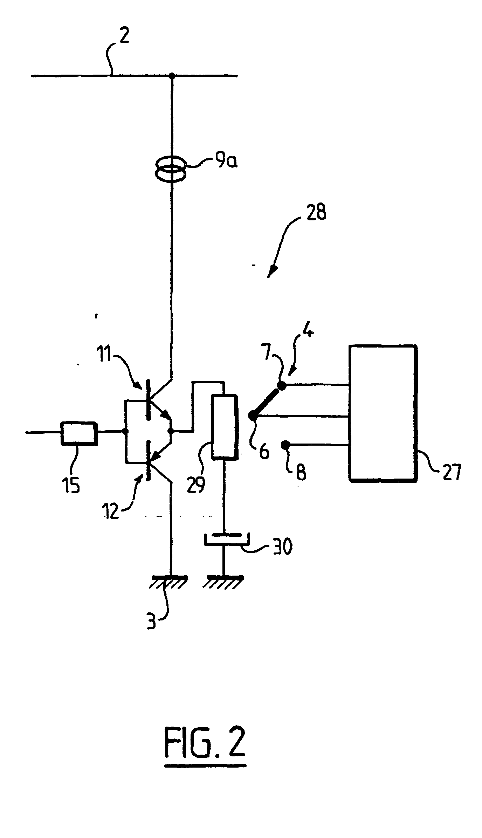

En se reportant maintenant à la figure 2, on voit que le dispositif de détection 28 représenté se différencie de celui décrit en référence à la figure 1 par le fait que les bobines 9 et 10 sont supprimées, le collecteur du transistor 11 étant relié au pôle 2 de la ligne téléphonique au travers du limiteur de courant 9a et le collecteur du transistor 12 étant directement relié au pôle 3 de la ligne téléphonique, que les émetteurs communs des transistors 11 et 12 sont reliés au pôle 3 de la ligne téléphonique au travers d'une bobine 29 et d'un condensateur 30 de stockage d'énergie électrique, cette bobine 29 étant placée dans le voisinage de l'organe mobile 5 du relais 4.

Ce dispositif de détection 28 fonctionne comme le dispositif de détection 1.

En effet, à la mise sous tension de la ligne téléphonique 2, 3, sous l'effet du comparateur 14 qui fait que le transistor 12 est bloqué et que le transistor 11 est passant, un courant circule au travers du transistor 11, de la bobine 29 et du condensateur 30 qui se charge. Ce courant produit une impulsion électrique qui dure jusqu'à ce que ce condensateur soit chargé. Cette impulsion électrique provoque l'actionnement de l'organe mobile 5 du relais 4 de manière à l'amener à sa première position en contact avec le premier plot de contact 7 de ce relais ou le maintient dans cette position. Quand le condensateur 30 est chargé, le courant ne passe plus.

A la coupure de la ligne téléphonique 2, 3, sous l'effet du comparateur 14 qui fait que le transistor 11 passe à son état bloqué et le transistor 12 devient passant, le condensateur 30 se décharge au travers de la bobine 29 via le transistor 12, produisant une impulsion électrique qui provoque l'actionnement de l'organe mobile 5 du relais 4 pour le faire passer de sa première position précitée à sa seconde position en contact avec le second plot de contact 8 de ce relais.

La présente invention ne se limite pas aux exemples ci-dessus décrits. Bien des variantes de réalisation sont possibles sans sortir du cadre défini par les revendications annexées.

## Revendications

1. Dispositif de détection de coupure d'une ligne électrique en particulier d'une ligne téléphonique, **caractérisé par le fait qu'**il comprend un relais bistable (4) comprenant un organe mobile (5) de changement d'état susceptible d'être activé par au moins une bobine (9, 10) et dont les plots de connexion extérieure (6, 7, 8) sont susceptibles d'être reliés à des moyens extérieurs, des moyens (11) pour délivrer une impulsion électrique à ladite au moins une bobine lors de la mise sous tension de ladite ligne électrique et produite par l'énergie électrique de cette dernière, afin de placer ledit relais à un premier état, et des moyens (12) pour délivrer une impulsion électrique à ladite au moins une bobine lors de la coupure de ladite ligne électrique et produite par des moyens (13) de stockage d'énergie électrique chargés par la ligne électrique, afin de placer ledit relais à un second état.

2. Dispositif selon la revendication 1, **caractérisé par le fait que** lesdits moyens pour délivrer une impulsion électrique lors de la coupure de ladite ligne comprennent des moyens (21) pour retarder d'un délai prédéterminé cette impulsion électrique par rapport au début d'une coupure de la ligne électrique et pour ne délivrer cette impulsion électrique que si cette coupure est maintenue pendant une durée au moins égale audit délai.

3. Dispositif selon l'une des revendications 1 et 2, **caractérisé par le fait qu'**il comprend des moyens de commande agissant sur lesdits moyens pour délivrer lesdites impulsions électriques en fonction de la valeur de la tension de ladite ligne électrique par rapport à une valeur de référence.

4. Dispositif selon l'une quelconque des revendications précédentes, **caractérisé par le fait que** lesdits moyens pour délivrer lesdites impulsions électriques comprennent deux transistors (11, 12) dont les émetteurs sont reliés entre eux et dont les collecteurs sont respectivement reliés à une borne d'une première et d'une seconde bobines (9, 10) correspondant à ladite au moins une bobine, lesdits émetteurs étant reliés à l'un desdits pôles via un condensateur (13) de stockage d'énergie électrique et les bases desdits transistors étant reliées à la sortie d'un comparateur de commande (14) susceptible de prendre un premier état lorsque la tension de la ligne électrique est supérieure à une valeur prédéterminée et un second état lorsque la tension de la ligne électrique est inférieure à cette valeur prédéterminée, les autres bornes desdites bobines étant reliées aux pôles de ladite ligne électrique, de telle sorte que lorsque la sortie dudit comparateur passe à son premier état, lesdits pôles sont connectés au travers d'une desdites première et seconde bobines, d'un desdits transistors et dudit condensateur, l'impulsion électrique étant délivrée à cette bobine durant la charge de ce condensateur, et que lorsque la sortie dudit comparateur passe à son second état, le condensateur chargé se décharge au travers de l'autre transistor et de l'autre bobine, l'impulsion électrique étant délivrée à cette autre bobine durant la décharge dudit condensateur.

5. Dispositif selon l'une quelconque des revendications 1 à 3, **caractérisé par le fait que** lesdits moyens pour délivrer lesdites impulsions électriques comprennent deux transistors (11, 12) dont les émetteurs sont reliés entre eux et à une borne d'une bobine (29) de ladite au moins une bobine et dont les collecteurs sont respectivement reliés aux pôles de la ligne électrique, l'autre borne de ladite bobine étant reliée à l'un des pôles de la ligne électrique via un condensateur (30), les bases desdits transistors étant reliées à la sortie d'un comparateur de commande (14) susceptible de prendre un premier état lorsque la tension de la ligne électrique est supérieure à une valeur prédéterminée et un second état lorsque la tension de la ligne électrique est inférieure à cette valeur prédéterminée, de telle sorte que lorsque la sortie dudit comparateur passe à son premier état, lesdits pôles sont connectés au travers d'un desdits transistors, de ladite bobine et dudit condensateur, l'impulsion électrique étant délivrée à cette bobine durant la charge de ce condensateur, et que lorsque la sortie dudit comparateur passe à son second état, le condensateur chargé se décharge au travers de ladite bobine et de l'autre transistor, l'impulsion électrique étant délivrée à cette bobine durant la décharge dudit condensateur.

6. Dispositif selon l'une des revendications 4 et 5, **caractérisé par le fait qu'**il comprend un autre condensateur (21) de stockage d'énergie électrique de la ligne électrique, ce condensateur étant monté de façon à se décharger en cas de coupure de cette dernière et étant relié à une entrée dudit comparateur, de telle sorte que lorsque la tension délivrée par l'autre condensateur passe en deça de ladite valeur prédéterminée au bout d'un délai de retard par rapport à l'instant de la coupure, ledit comparateur passe à son second état précité.

## Claims

1. Appliance for detecting an open circuit in an electrical line, in particular a telephone line, **characterized in that** it comprises a bistable relay (4) comprising a mobile state transition unit (5) capable of being activated by at least one coil (9, 10) and the external connection pins (6, 7, 8) of which are capable of being connected to external means, means (11) of delivering an electric pulse to the said at least one coil when the said electric line is powered up and produced by the electric power of the latter, in order to place the said relay in a first state, and means (12) of delivering an electric pulse to the said at least one coil when the said electric line is in open circuit condition and produced by electric energy storage means (13) charged by the electric line, in order to place the said relay in a second state.

2. Appliance according to Claim 1, **characterized in that** the said means of delivering an electric pulse when the said line is in open circuit condition comprise means (21) of delaying this electric pulse by a predetermined delay relative to the beginning of an open circuit condition in the electric line and of delivering this electric pulse only if this open circuit condition is maintained for a duration at least equal to the said delay.

3. Appliance according to either one of Claims 1 or 2, **characterized in that** it comprises control means acting on the said means of delivering the said electric pulses on the basis of the value of the voltage of the said electric line relative to a reference value.

4. Appliance according to any one of the preceding claims, **characterized in that** the said means of delivering the said electric pulses comprise two transistors (11, 12) whose emitters are interconnected and whose collectors are connected respectively to a terminal of a first and of a second coil (9, 10) corresponding to the said at least one coil, the said emitters being connected to one of the said poles via an electric energy storage capacitor (13) and the bases of the said transistors being connected to the output of a control comparator (14) capable of taking a first state when the voltage of the electric line is greater than a predetermined value and a second state when the voltage of the electric line is less than this predetermined value, the other terminals of the said coils being connected to the poles of the said electric line, so that when the output of the said comparator passes to its first state, the said poles are connected through one of the said first and second coils, one of the said transistors and the said capacitor, the electric pulse being delivered to this coil during the charging of this capacitor, and that when the output of the said comparator passes to its second state, the charged capacitor discharges through the other transistor and the other coil, the electric pulse being delivered to this other coil during the discharging of the said capacitor.

5. Appliance according to any one of Claims 1 to 3, **characterized in that** the said means of delivering the said electric pulses comprise two transistors (11, 12) whose emitters are interconnected and connected to one terminal of one coil (29) of the said at least one coil and whose collectors are connected respectively to the poles of the electric line, the other terminal of the said coil being connected to one of the poles of the electric line via a capacitor (30), the bases of the said transistors being connected to the output of a control comparator (14) capable of taking a first state when the voltage of the electric line is greater than a predetermined value and a second state when the voltage of the electric line is less than this predetermined value, so that when the output of the said comparator passes to its first state, the said poles are connected through one of the said transistors, the said coil and the said capacitor, the electric pulse being delivered to this coil during the charging of this capacitor, and that when the output of the comparator passes to its second state, the charged capacitor discharges through the said coil and the other transistor, the electric pulse being delivered to this coil during the discharging of the said capacitor.

6. Appliance according to one of Claims 4 and 5, **characterized in that** it comprises another capacitor (21) for storing electric energy of the electric line, this capacitor being fitted in such a way as to discharge in the event of an open line condition in the line and being connected to an input of the said comparator such that, when the voltage delivered by the other capacitor falls below the said predetermined value at the end of a delay period relative to the moment of entering the open line condition, the said comparator passes to its aforementioned second state.

## Patentansprüche

1. Vorrichtung zur Erfassung einer Unterbrechung in einer elektrischen Leitung, insbesondere einer Telefonleitung, **dadurch gekennzeichnet, dass** sie aufweist: ein bistabiles Relais (4), das ein zur Veränderung seines Zustands bewegbares Glied (5) aufweist, das in der Lage ist, über wenigstens eine Spule (9, 10) aktiviert zu werden; und dessen äußere Anschlusskontakte (6, 7, 8) geeignet sind, um mit äußeren Mitteln verbunden zu werden, Mittel (11), die dazu dienen, der wenigstens einen Spule beim Anlegen einer Spannung an die elektrische Leitung einen elektrischen Impuls zuzuführen, der mittels der elektrischen Energie der elektrischen Leitung erzeugt wird, um das Relais in einen ersten Zustand zu versetzen, sowie Mittel (12), die dazu dienen, der wenigstens einen Spule bei einer Unterbrechung in der elektrischen Leitung einen elektrischen Impuls zuzuführen, der von Mitteln (13) zur Speicherung elektrischer Energie erzeugt wird, die über die elektrische Leitung aufgeladen werden, um das Relais in einen zweiten Zustand zu versetzen.

2. Vorrichtung nach Anspruch 1, **dadurch gekennzeichnet, dass** die Mittel zur Zuführung eines elektrischen Impulses im Falle einer Unterbrechung in der Leitung Mittel (21) enthalten, die dazu dienen, diesen elektrischen Impuls in Bezug auf den Einsetzzeitpunkt einer Unterbrechung in der elektrischen Leitung über eine vorbestimmte Verzögerungszeit hinweg zu verzögern und diesen elektrischen Impuls erst dann zu liefern, wenn diese Unterbrechung während einer Dauer, die wenigstens gleich der Verzögerungszeit ist, aufrecht erhalten wird.

3. Vorrichtung nach einem der Ansprüche 1 und 2, **dadurch gekennzeichnet, dass** sie Betätigungsmittel aufweist, die in Abhängigkeit von dem auf einen Referenzwert bezogenen Wert der Spannung an der elektrischen Leitung auf die Mittel zur Zuführung der elektrischen Impulse einwirken.

4. Vorrichtung nach einem der vorhergehenden Ansprüche, **dadurch gekennzeichnet, dass** die Mittel zur Zuführung der elektrischen Impulse zwei Transistoren (11, 12) aufweisen, deren Emitter miteinander verbunden sind und deren Kollektoren jeweils mit einem Anschluss einer ersten und einer zweiten Spule (9, 10) verbunden sind, die der wenigstens einen Spule zugeordnet sind, wobei die Emitter über einen Kondensator (13) zur Speicherung elektrischer Energie mit einem der Pole verbunden sind und die Basen der Transistoren mit dem Ausgang eines Betätigungskomparators (14) verbunden sind, der in der Lage ist, einen ersten Zustand einzunehmen, wenn die Spannung an der elektrischen Leitung größer ist als ein vorbestimmter Wert, und einen zweiten Zustand einzunehmen, wenn die Spannung an der elektrischen Leitung kleiner ist als dieser vorbestimmte Wert, wobei die anderen Anschlüsse der Spulen mit den Polen der elektrischen Leitung verbunden sind, in der Weise, dass, wenn der Ausgang des Komparators in seinen ersten Zustand übergeht, die Pole über eine der ersten und zweiten Spulen, einen der Transistoren und den Kondensator verbunden sind, wobei der elektrische Impuls während des Aufladvorgangs des Kondensators der Spule zugeführt wird, und dass, wenn der Ausgang des Komparators in seinen zweiten Zustand übergeht, der aufgeladene Kondensator über den anderen Transistor und die andere Spule entladen wird, wobei der elektrische Impuls während des Entladevorgangs des Kondensators der anderen Spule zugeführt wird.

5. Vorrichtung nach einem beliebigen der Ansprüche 1 bis 3, **dadurch gekennzeichnet, dass** die Mittel zur Zuführung der elektrischen Impulse zwei Transistoren enthalten, deren Emitter untereinander und mit einem Anschluss einer Spule (29) der wenigstens einen Spule verbunden sind und deren Kollektoren jeweils mit den Polen der elektrischen Leitung verbunden sind, wobei der andere Anschluss der Spule über einen Kondensator (30) an einen der Pole der elektrischen Leitung angeschlossen ist, die Basen der Transistoren mit dem Ausgang eines Betätigungskomparators (14) verbunden sind, der in der Lage ist, einen ersten Zustand einzunehmen, wenn die Spannung an der elektrischen Leitung größer ist als ein vorbestimmter Wert, und einen zweiten Zustand einzunehmen, wenn die Spannung an der elektrischen Leitung kleiner ist als dieser vorbestimmte Wert, in der Weise, dass bei einem Übergang des Ausgangs des Komparators in seinen zweiten Zustand die Pole über einen der Transistoren, die Spule und den Kondensator verbunden sind, wobei der elektrische Impuls während des Auflagevorgangs des Kondensators dieser Spule zugeführt wird, und dass bei einem Übergang des Ausgangs des Komparators in seinen zweiten Zustand der aufgeladene Kondensator über die Spule und den anderen Transistor entladen wird, wobei der elektrische Impuls während des Entladevorgangs des Kondensators dieser Spule zugeführt wird.

6. Vorrichtung nach einem der Ansprüche 4 und 5, **dadurch gekennzeichnet, dass** sie einen weiteren Kondensator (21) zur Speicherung elektrischer Energie aus der elektrischen Leitung aufweist, wobei dieser Kondensator in der Weise angebracht ist, um im Falle einer Unterbrechung in der Letzteren entladen zu werden, und er mit einem Eingang des Komparators in der Weise verbunden ist, dass der Komparator in seinen zweiten vorerwähnten Zustand übergeht, wenn die von dem weiteren Kondensator gelieferte Spannung bis zum Ablauf einer Verzögerungszeit in Bezug auf den Zeitpunkt der Unterbrechung den vorbestimmten Wert passiert.
